# EUROPÄISCHE PATENTSCHRIFT

(11) **EP 1 230 558 B1**
(45) Veröffentlichungstag und Bekanntmachung des Hinweises auf die Patenterteilung: **13.02.2008**
(21) Anmeldenummer: 01985755.6
(22) Anmeldetag: 24.09.2001
(51) Int. Cl.: G01R 33/07

(54) **HALL-SENSOR-BAUELEMENT**
HALL-SENSOR COMPONENT
COMPOSANT A CAPTEUR HALL

(30) Priorität: 26.09.2000 DE 10047994
(43) Veröffentlichungstag der Anmeldung: 14.08.2002
(73) Patentinhaber: ZF Lemförder Metallwaren AG, 49441 Lemförde (DE)
(72) Erfinder: KLIEMANNEL, Wolfgang, 49448 Lemförde (DE)
(86) Internationale Anmeldenummer: PCT/DE2001/003668
(87) Internationale Veröffentlichungsnummer: WO 2002/027344

(56) Entgegenhaltungen:
- DE-A- 19 539 458
- US-A- 4 791 311
- US-A- 5 218 298
- US-A- 5 517 112
- US-A- 5 844 411

## Beschreibung

Die Erfindung betrifft ein Hall-Sensor-Bauelement mit den Merkmalen nach dem Oberbegriff des Patentanspruchs 1

Hall-Sensoren sind aus dem Stand der Technik bekannt. Im Prinzip bestehen sie aus einer leitfähigen Sensorfläche, die von einem Strom durchflossen wird. Tritt nun ein magnetisches Feld in Wechselwirkung mit der von dem Strom durchflossenen Sensorfläche, so kommt es aufgrund der Lorentzkraft zu einer Ablenkung der den Strom hervorrufenden Ladungsträger, wodurch ein elektrisches Feld in der Sensorfläche erzeugt wird, welches Ursache für eine an seitlichen Rändern der Sensorfläche anliegenden Spannung ist. Diese als Hall-Spannung bezeichnete Spannung ist proportional zum Produkt aus der magnetischen Flussdichte des Magnetfeldes und dem die Sensorfläche durchfließenden Strom, so das über eine Messung der Hall-Spannung bei bekanntem Strom die magnetische Flussdichte bis auf einen Proportionalitätsfaktor bestimmt werden kann, der unter anderem von den geometrischen Abmessungen der Sensorfläche abhängig ist.

Hall-Sensoren werden zum Beispiel in Form von Hall-Sensor-Bauelementen auf dem Markt vertrieben, wobei dem eigentlichen Hall-Sensor eine Verarbeitungsvorrichtung nachgeschaltet ist, die das von dem Hall-Sensor abgegebene Hall-Signal für eine Auswertung aufbereitet und ein dem Hall-Signal zugeordnetes Signal als Ausgangssignal abgibt. Sowohl der Hall-Sensor als auch die Verarbeitungsvorrichtung sind dabei in einem einzigen Gehäuse integriert.

Hall-Sensor-Bauelemente werden für unterschiedliche Anwendungsmöglichkeiten mit unterschiedlichen Verarbeitungsvorrichtungen ausgestattet. Eine Anwendungsmöglichkeit ist zum Beispiel das Bestimmen der magnetische Flußdichte des auf den Hall-Sensor wirkenden magnetischen Feldes mit Hilfe des Hall-Sensor-Bauelementes. Dafür ist die Verarbeitungsvorrichtung bevorzugt derart ausgelegt, dass zwischen der Signalstärke des Ausgangssignals und der magnetischen Flussdichte in möglichst weiten Bereichen eine lineare Abhängigkeit besteht.

Eine andere Anwendungsmöglichkeit ist die Verwendung eines Hall-Sensor-Bauelementes in Verbindung mit einem Magneten als eine mit wenig Reibverlusten behaftete Schaltvorrichtung, die mit einem Schalthebel in wenigstens zwei Schaltzustände geschaltet werden kann. Dabei ist an dem Schalthebel ein Magnet vorgesehen, der in einem ersten Schaltzustand der beiden Schaltzustände in den Wirkbereich eines dem ersten Schaltzustand zugeordneten Hall-Sensor-Bauelementes gebracht ist. Unter Wirkbereich ist dabei der räumliche Bereich um das Hall-Sensor-Bauelement zu verstehen, in den der Magnet gebracht werden muss, um eine derartige Erhöhung des Betrages der Hall-Spannung herbeizuführen, dass ein durch die Verarbeitungsvorrichtung vorgegebener erster Schwellenwert überschritten wird. Durch die Festlegung dieses Schwellenwertes kann somit der zwischen dem Magnet und dem in dem Hall-Sensor-Bauelement vorgesehenen Hall-Sensor zu unterschreitende räumliche Abstand eingestellt werden, bei dem der erste Schaltzustand als eingeschaltet gilt. Ferner ist durch die Verarbeitungsvorrichtung ein zweiter Schwellenwert vorgegeben, durch den der zwischen dem Magnet und dem Hall-Sensor zu überschreitende räumliche Abstand eingestellt ist, bei dem der erste Schaltzustand als ausgeschaltet gilt. Der zweite Schwellenwert kann sich vom ersten Schwellenwert unterscheiden, so dass von der Verarbeitungsvorrichtung eine sogenannte Schalthysterese vorgesehen ist. Die Verarbeitungsvorrichtung kann zum Realisieren dieser Schalthysterese zum Beispiel mit einem Schmitt-Trigger als Schwellenwertgeber ausgestattet sein. Selbstverständlich kann bei solchen reibungsarmen Schaltvorrichtungen auch das Hall-Sensor-Bauelement am Schalthebel angeordnet sein. In diesem Fall ist das Hall-Sensor-Bauelement durch das Bewegen des Schalthebels in das magnetische Feld des Magneten einbringbar.

Je mehr elektronische Schaltkreise allerdings dem eigentlichen Hall-Sensor in dem Hall-Sensor-Bauelement nachgeschaltet sind, je höher ist auch das Risiko eines Ausfalls des Hall-Sensor-Bauelementes aufgrund eines Defekts in einem von diesen Schaltkreisen. Fällt nun ein herkömmliches Hall-Sensor-Bauelement aufgrund eines derartigen Defektes aus, so besteht häufig das Problem, dass die Funktionsfähigkeit des Hall-Sensor-Baulementes im eingebauten Zustand bzw. im Betrieb nicht überprüft werden kann, so dass der Defekt nicht erkannt wird.

Die DE 195 39 458 A1 offenbart ein Hall-Sensor Bauelement mit einem von einem elektrischen Strom durchflossenen Hall-Sensor, von dem ein Hall-Signal abgegeben wird.

Dem Hall-Sensor Bauelement nachgeschaltet ist eine Verarbeitungseinrichtung in der Ausbildung eines Mikrocomputers, welcher ein Eingangssignal verarbeitet und aufbereitete Daten weitergibt. Dem Hall-Sensor Bauelement wird ein Testimpuls zur Selbsttestfunktion des Hall-Sensors zugeführt. Die Zuführung des Testimpulses und die damit verbundene Invertierung des Ausgangssignals stellt allerdings stets nur eine momentane Testfunktion dar und bildet keine ständige Überwachung des Hall-Sensors. Zudem stellen der Hall-Sensor und die Verarbeitungseinheit getrennte Bauteile dar und sind nicht in einer Baugruppe integriert. Der Testimpuls wird von der Verarbeitungseinheit an das Hall-Sensor Bauelement gegeben, wobei die Reaktionen der Verarbeitungseinheit wiederum zugeführt und durch diese ausgewertet werden. Erst nach Beendigung des Tests werden der Verarbeitungseinheit die Ausgangssignale der Hall-Sensoren zur weiteren Verarbeitung zugeführt. Somit wird deutlich, dass das Hall-Signal und der Testimpuls vollkommen getrennte Signale darstellen und sind somit auch nicht miteinander verknüpft sind.

Des Weiteren zeigt die US 4,791,311 ebenfalls ein Hall-Sensor-Bauelement mit einem von einem Hall-Sensor abgebbaren Hall-Signal, das von auf den Hall-Sensor einwirkenden magnetischen Feld und dem elektrischen Strom abhängig ist. Das von einer in dem Hall-Sensor-Bauelement angeordneten Logikschaltung bereitgestellte Diagnosesignal steuert eine Stromquelle und erzeugt dadurch einen Strom, welcher anzeigt, ob das Hall-Sensor-Bauelement anwesend ist oder nicht. Das Diagnosesignal ist nicht mit dem Hall-Sensor verknüpft, sondern wird parallel zu diesem verwendet, da das Signal des Hall-Sensors getrennt hiervon die Stromquelle ansteuert. Es wird somit die Ausgangsbeschaltung diagnostiziert, nicht das eigentliche Hall-Element.

Der Erfindung liegt die Aufgabe zugrunde, ein Hall-Sensor-Bauelement zu schaffen, bei dem die Möglichkeit zur Überprüfung seiner Funktionsfähigkeit verbessert ist.

Erfindungsgemäß wird diese Aufgabe mit einem Hall-Sensor-Bauelement mit den Merkmalen nach dem Patentanspruch 1 gelöst. Bevorzugte Weiterbildungen sind in den Unteransprüchen beschrieben.

Das erfindungsgemäße Hall-Sensor-Bauelement weist einen von einem elektrischen Strom durchflossenen Hall-Sensor und eine Verarbeitungsvorrichtung zum Verarbeiten eines Eingangssignals auf. Von dem Hall-Sensor wird ein Hall-Signal abgegeben, welches von einem auf den Hall-Sensor wirkenden magnetischen Feld und dem elektrischen Strom abhängig ist. Dem Hall-Sensor ist die Verarbeitungsvorrichtung nachgeschaltet, von welcher ein dem Einganssignal zugeordnetes bzw. abhängiges Ausgangssignal abgegeben wird. Der Hall-Sensor und die Verarbeitungsvorrichtung bilden eine Baugruppe, der ein von einem Signalgenerator erzeugtes Diagnosesignal zugeführt wird. Das Hall-Signal wird mittelbar oder unmittelbar mit dem Diagnosesignal verknüpft, wobei das mit dem Diagnosesignal verknüpfte Hall-Signal der Verarbeitungsvorrichtung als Eingangssignal zugeführt wird.

Da erfindungsgemäß das mit dem Diagnosesignal unmittelbar oder mittelbar verknüpfte Hall-Signal der Verarbeitungsvorrichtung zugeführt wird, ist das Ausgangssignal auch von dem Diagnosesignal in charakteristischer Weise beeinflusst. Somit können aber von dem Ausgangssignal erfindungsgemäß zwei Signalanteile abgeleitet werden, von denen ein erster Signalanteil das Magnetfeld und der zweite Signalanteil das Diagnosesignal charakterisiert, wobei nachfolgend der erste Signalanteil des Ausgangssignal als Magnetanteil und der zweite Signalanteil des Ausgangssignals als Diagnoseanteil bezeichnet wird.

Das verwendete Diagnosesignal kann ein beliebiges Signal sein, sofern aus dem Ausgangssignal der Diagnoseanteil und der Magnetanteil ableitbar sind. Bevorzugt handelt es sich bei dem Diagnosesignal jedoch um ein periodisches Rechtecksignal.

Das Diagnosesignal kann dem Hall-Sensor auf unterschiedliche Weise zugeführt werden. Gemäß einer ersten Alternative kann das Hall-Signal unmittelbar mit dem Diagnosesignal verknüpft werden. Die unmittelbare Verknüpfung von Hall- und Diagnosesignal erfolgt erst an bzw. hinter dem Ausgang des Hall-Sensors und kann zum Beispiel dadurch realisiert werden, dass das Hall-Signal und das Diagnosesignal mittels eines analogen Addierers zu einem Mischsignal addiert werden, welches dann das Eingangssignal der Verarbeitungsvorrichtung bildet.

Gemäß einer zweiten Alternative kann das Hall-Signal aber auch mittelbar mit dem Diagnosesignal verknüpft werden, indem der den Hall-Sensor durchfließende elektrische Strom in Abhängigkeit vom Diagnosesignal gesteuert wird.

Wird dem Hall-Sensor bei mittelbarer Verknüpfung von Hall-Signal und Diagnosesignal ein periodisches Rechtecksignal als Diagnosesignal zugeführt, welches abwechselnd als Signalzustand einen logischen H-Pegel und einen logischen L-Pegel annimmt, so wird bevorzugt der den Hall-Sensor durchfließende Strom in Abhängigkeit von dem Signalzustand des Rechtecksignals ein- bzw. ausgeschaltet. Das heißt, dass der Strom eingeschaltet wird, wenn das Rechecksignal einen logischen H-Pegel aufweist und der Strom ausgeschaltet wird, wenn das Rechtecksignal einen logischen L-Pegel aufweist oder umgekehrt. Dabei kann der den Hall-Sensor durchfließende Strom von dem Signalgenerator geliefert werden.

Der Signalgenerator kann außerhalb von dem Hall-Sensor-Bauelement angeordnet sein, wobei das Diagnosesignal über einen an dem Hall-Sensor-Bauelement vorgesehenen Anschluss zugeführt wird. Bevorzugt ist der Signalgenerator aber in dem Hall-Sensor-Bauelement integriert.

Weist die Verarbeitungsvorrichtung hinsichtlich ihres Eingangs eine Schalthysterese mit zwei Schwellenwerten auf, und handelt es sich bei dem Diagnosesignal um ein periodisches Signal, so wird bevorzugt die Frequenz des Diagnosesignals in Abhängigkeit von dem Hall-Signal verändert. In diesem Fall weist das mit dem Hall-Signal verknüpfte Diagnosesignal innerhalb einer Periode wenigstens einmal eine ausreichende Höhe auf, um einen ersten der Schwellenwerte zu überschreiten und wenigstens einmal eine ausreichende Tiefe auf, um den zweiten Schwellenwert zu unterschreiten. Der Signalgenerator ist dabei als spannungsgesteuerter Oszillator (VCO) ausgelegt, der in Abhängigkeit von der Höhe der Hall-Spannung die Frequenz des Diagnosesignals verändert.

Ferner kann der Verarbeitungsvorrichtung eine Auswertevorrichtung nachgeschaltet sein, von welcher der Diagnoseanteil als solcher erkannt und ausgewertet wird. Auf der Basis dieser Auswertung wird dann erkannt, ob das Hall-Sensor-Bauelement zumindest hinsichtlich der Verarbeitungsvorrichtung ordnungsgemäß arbeitet.

Das erfindungsgemäße Hall-Sensor-Bauelement bildet ein diagnostizierbares Bauelement, welches bevorzugt dort eingesetzt werden kann, wo aus Sicherheitsgründen eine Erkennung des Ausfalls des Sensors wünschenswert wäre, um Schaden von Personen oder Einrichtungen abzuwenden.

Ein mögliches Einsatzgebiet für das erfindungsgemäße Hall-Sensor-Bauelement ist zum Beispiel das Gebiet der Kraftfahrzeugelektronik, insbesondere der Gang-Schaltungen, für welche Hall-Sensor-Bauelemente zum Ausbilden einer reibungsarmen Schaltvorrichtung verwendet werden.

In einer derartigen Schaltvorrichtung kann, um den aktuellen Schaltzustand des Schalthebels in der Fahrgastkabine zu erkennen, beispielsweise am Schalthebel der Gangschaltung ein Magnet angeordnet sein, der bei einer bestimmten Schaltstellung in den Wirkbereich eines dieser zugeordneten Hall-Sensor-Bauelementes eintritt. Bevorzugt wird dieses Hall-Sensor-Bauelement durch das erfindungsgemäße Hall-Sensor-Bauelement gebildet, so dass ein Ausfall desselben von einer im Kraftfahrzeug angeordneten Steuerelektronik erkannt werden kann. Somit ist es möglich, mittels der im Kraftfahrzeug angeordneten Steuerelektronik die Funktionsfähigkeit des in der Gangschaltung verwendeten Hall-Sensor-Bauelementes zu überprüfen. Wird der Ausfall des bzw. eines in der Gangschaltung verwendeten Hall-Sensor-Bauelementes erkannt, ist es möglich, diesen Ausfall dem Fahrer anzuzeigen und/oder ein dem Ausfall zugeordnetes Sicherheitsprogramm ablaufen zu lassen, um ein mögliches falsches Schalten des Getriebes zu verhindern und somit einen möglichen Schaden von dem Fahrer bzw. von dem Fahrzeug abzuwenden. Selbstverständlich kann auch hier das Hall-Sensor-Bauelement am Schalthebel angeordnet sein. In diesem Fall ist das Hall-Sensor-Bauelement durch das Bewegen des Schalthebels in das magnetische Feld des Magneten einbringbar.

Die Erfindung wird anhand bevorzugter Ausführungsformen unter Bezugnahme auf die Zeichnung beschrieben. In der Zeichnung zeigen:
- Figur 1: ein Blockschaltbild eines erfindungsgemäßen Hall-Sensor-Bauelementes gemäß einer ersten Ausführungsform der Erfindung,
- Figur 2: eine schematische Darstellung des Hall-Sensors und des Signalgenerators gemäß der ersten Ausführungsform und
- Figur 3: ein Blockschaltbild eines erfindungsgemäßen Hall-Sensor-Bauelementes gemäß einer zweiten Ausführungsform der Erfindung.

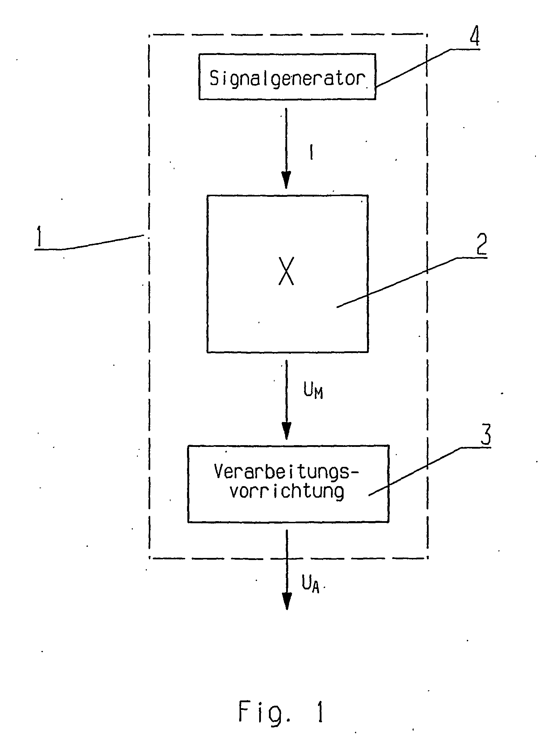

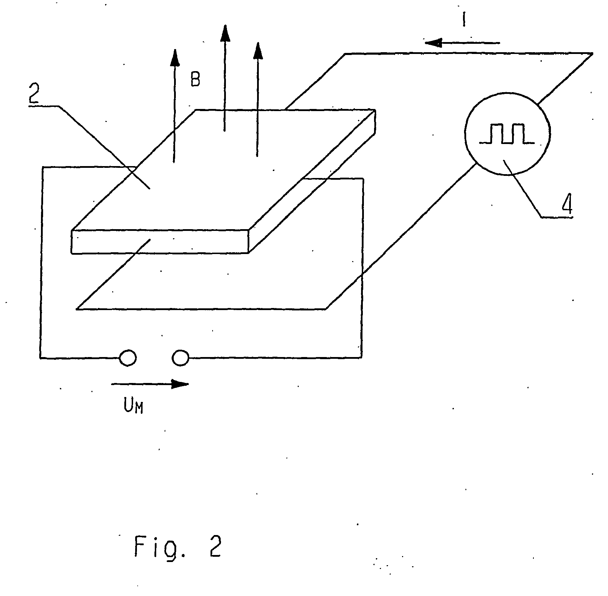

Aus den Figuren 1 und 2 sind ein Blockschaltbild und eine schematische Darstellung eines erfindungsgemäßen Hall-Sensor-Bauelementes gemäß einer ersten Ausführungsform der Erfindung ersichtlich. Das Hall-Sensor-Bauelement 1 weist einen Hall-Sensor 2 und eine Verarbeitungsvorrichtung 3 auf, welche in einem nicht dargestellten Gehäuse integriert sind. Von einem ebenfalls in dem Gehäuse integrierten Signalgenerator 4 wird ein Strom I erzeugt und abgegeben, der den Hall-Sensor 2 durchfließt. Der Hall-Sensor 2 ist einem magnetischen Feld ausgesetzt, welches Ursache für eine von dem Hall-Sensor 2 abgegebene Hall-Spannung ist, die proportional zu dem Produkt aus dem Strom I und der magnetischen Flußdichte B des Magnetfeldes ist. Der zeitliche Verlauf des von dem Signalgenerator 4 erzeugten Stroms I entspricht einem periodischen Rechtecksignal, dessen charakteristischer Verlauf sich auch in dem von dem Hall-Sensor abgegebenen Signal U_{M} niederschlägt. Dem Strom I ist hier eine Doppelfunktion zugeordnet. Zum einen dient der Strom I zum Betreiben des Hall-Sensors 2, und zum anderen dient er aufgrund seiner periodischen Charakteristik als Diagnosesignal. Somit ist das Signal U_{M} ein Mischsignal, wobei sich der Betrag der magnetischen Flussdichte B in der Amplitude des Mischsignals niederschlägt, und wobei sich die Frequenz des Stroms I in dem periodischen Anteil dieses Mischsignals niederschlägt. Das Mischsignal U_{M} weist also einen Diagnosesignalanteil und einen Hall-Spannungsanteil auf.

Das Mischsignal U_{M} wird der Verarbeitungsvorrichtung 3 zugeführt, von der ein dem Mischsignal U_{M} zugeordnetes bzw. abhängiges Signal U_{A} als Ausgangssignal abgegeben wird, welches ebenfalls einen Diagnosesignalanteil (Diagnoseanteil) und einen Hall-Spannungsanteil (Magnetanteil) aufweist.

Der Diagnoseanteil des Ausgangssignal U_{A} wird von einer nicht dargestellten und der Verarbeitungsvorrichtung 3 nachgeschalteten Auswertevorrichtung erkannt und ausgewertet, so dass aufgrund der Auswertung festgestellt werden kann, ob das Hall-Sensor-Bauelement zumindest hinsichtlich der Verarbeitungseinheit ordnungsgemäß arbeitet.

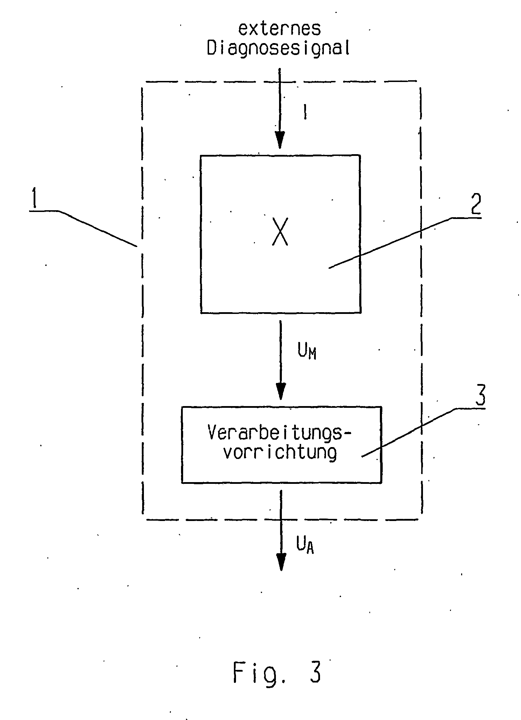

Aus Figur 3 ist ein Blockschaltbild eines erfindungsgemäßen Hall-Sensor-Bauelementes gemäß einer zweiten Ausführungsform der Erfindung ersichtlich, wobei die für die Merkmale nach der zweiten Ausführungsform verwendeten Bezugszeichen mit den für dieselben oder ähnliche Merkmale verwendeten Bezugszeichen nach der ersten Ausführungsform übereinstimmen.

Im wesentlichen stimmt die zweite Ausführungsform bis auf die Integration des Signalgenerators 4 in das Hall-Sensor-Bauelement mit der ersten Ausführungsform überein. Gemäß der zweiten Ausführungsform ist der Signalgenerator 4 nämlich außerhalb des Hall-Sensor-Bauelementes angeordnet, wobei der aus dem Hall-Sensor 2 und der Verarbeitungsvorrichtung 3 gebildeten Baugruppe das von dem Signalgenerator erzeugte Diagnosesignal als externes Diagnosesignal zugeführt wird.

### Bezugszeichenliste:

- 1: Hall-Sensor-Bauelement
- 2: Hall-Sensor
- 3: Verarbeitungsvorrichtung
- 4: Signalgenerator

## Patentansprüche

1. Hall-Sensor-Bauelement mit
einem von einem elektrischen Strom durchfließbaren Hall-Sensor (2) von dem ein Hall-Signal abgegeben werden kann, welches von einem auf den Hall-Sensor (2) wirkenden magnetischen Feld und dem elektrischen Strom abhängig ist, und
einer dem Hall-Sensor (2) nachgeschalteten Verarbeitungsvorrichtung (3) zum Verarbeiten eines Eingangssignals und zum Abgeben eines dem Einganssignal zugeordnetes Ausgangssignals, **gekennzeichnet, durch** einer Signalgenerator (4) zum Bereitstellen eines Diagnosesignals,
das der aus dem Hall-Sensor (2) und der Verarbeitungsvorrichtung (3) gebildeten Baugruppe (2,3) zugeführt wird, so daß das Hall-Signal mit dem Diagnosesignal mittelbar oder unmittelbar verknüpft ist,
der Verarbeitungsvorrichtung (3) das mit dem Diagnosesignal verknüpfte Hall-Signal als Eingangssignal bereitgestellt wird, und
das Ausgangssignal einen auf das Diagnosesignal zurückführenden Signalanteil und einen auf das magnetische Feld zurückführenden Signalanteil aufweist.

2. Hall-Sensor-Bauelement nach Anspruch 1, **dadurch gekennzeichnet, dass** das von dem Hall-Sensor (2) abgegebenen Hall-Signal unmittelbar mit dem Diagnosesignal verknüpft ist.

3. Hall-Sensor-Bauelement nach Anspruch 2, **dadurch gekennzeichnet, dass** das Hall-Signal mit dem Diagnosesignal mittels eines analogen Addierers überlagert ist.

4. Hall-Sensor-Bauelement nach Anspruch 1, **dadurch gekennzeichnet, dass** das Hall-Signal mit dem Diagnosesignal mittelbar **dadurch** verknüpft ist, dass der den Hall-Sensor durchfließende elektrische Strom in Abhängigkeit von dem Diagnosesignal gesteuert ist.

5. Hall-Sensor-Bauelement nach einem der Ansprüche 1 bis 4, **dadurch gekennzeichnet, dass** das Diagnosesignal ein periodisches Rechtecksignal ist, welches abwechselnd einen logischen H-Pegel und einen logischen L-Pegel annimmt.

6. Hall-Sensor-Bauelement nach den Ansprüchen 4 und 5, **dadurch gekennzeichnet**, das der elektrische Strom bei einem logischen H-Pegel des Rechtecksignals eingeschaltet und bei einem logischen L-Pegel des Rechtecksignals ausgeschaltet ist.

7. Hall-Sensor-Bauelement nach einem der Ansprüche 1 bis 6, **dadurch gekennzeichnet, dass** der Signalgenerator (4) in das Hall-Sensor-Bauelement integriert ist.

## Claims

1. Hall sensor component, with
a Hall sensor (2) through which an electric current can flow, and which can output a Hall signal, which depends on a magnetic field which acts on the Hall sensor (2) and on the electric current, and
a processing device (3), which is connected downstream from the Hall sensor (2) for processing an input signal and for outputting an output signal which is associated with the input signal,
**characterized by** a signal generator (4) to provide a diagnostic signal,
which is fed from the module (2, 3) formed from the Hall sensor (2) and processing device (3), so that the Hall signal is linked indirectly or directly to the diagnostic signal,
the Hall signal, which is linked to the diagnostic signal, is provided to the processing device (3) as an input signal, and
the output signal has a signal portion which is derived from the diagnostic signal and a signal portion which is derived from the magnetic field.

2. Hall sensor component according to Claim 1, **characterized in that** the Hall signal which the Hall sensor (2) outputs is linked directly to the diagnostic signal.

3. Hall sensor component according to Claim 2, **characterized in that** the Hall signal is overlaid with the diagnostic signal by means of an analog adder.

4. Hall sensor component according to Claim 1, **characterized in that** the Hall signal is linked to the diagnostic signal indirectly, by the electric current which flows through the Hall sensor being controlled depending on the diagnostic signal.

5. Hall sensor component according to one of Claims 1 to 4, **characterized in that** the diagnostic signal is a periodic rectangular signal, which takes a logical H level and a logical L level alternately.

6. Hall sensor component according to Claims 4 and 5, **characterized in that** the electric current is switched on in the case of a logical H level of the rectangular signal, and switched off in the case of a logical L level of the rectangular signal.

7. Hall sensor component according to one of Claims 1 to 6, **characterized in that** the signal generator (4) is integrated into the Hall sensor component.

## Revendications

1. Composant détecteur à effet Hall, comprenant :
un capteur à effet Hall (2) qui peut être parcouru par un courant électrique et qui peut délivrer un signal de Hall qui est fonction d'un champ magnétique agissant sur le capteur à effet Hall (2) et du courant électrique, et
un dispositif de traitement (3) câblé en aval du capteur à effet Hall (2) et servant à traiter un signal d'entrée et à délivrer un signal de sortie en fonction du signal d'entrée,
**caractérisé par** un générateur de signal (4) servant à fournir un signal de diagnostic qui est appliqué à l'ensemble (2, 3) formé par le capteur à effet Hall (2) et le dispositif de traitement (3) de façon à coupler directement ou indirectement le signal de Hall au signal de diagnostic,
le signal de Hall couplé au signal de diagnostic est appliqué en tant que signal d'entrée au dispositif de traitement (3), et
le signal de sortie présente une composante de signal correspondant au signal de diagnostic et une composante de signal correspondant au champ magnétique.

2. Composant détecteur à effet Hall selon la revendication 1, **caractérisé en ce que** le signal de Hall délivré par le capteur à effet Hall (2) est couplé directement au signal de diagnostic.

3. Composant détecteur à effet Hall selon la revendication 2, **caractérisé en ce que** le signal de Hall est superposé au signal de diagnostic en utilisant un additionneur analogique.

4. Composant détecteur à effet Hall selon la revendication 1, **caractérisé en ce que** le signal de Hall est couplé indirectement au signal de diagnostic en commandant le courant électrique qui parcourt le capteur à effet Hall en fonction du signal de diagnostic.

5. Composant détecteur à effet Hall selon l'une des revendications 1 à 4, **caractérisé en ce que** le signal de diagnostic est un signal rectangulaire périodique qui alterne entre un niveau logique haut et un niveau logique bas.

6. Composant détecteur à effet Hall selon l'une des revendications 4 et 5, **caractérisé en ce que** le courant électrique est activé au niveau logique haut et désactivé au niveau logique bas du signal rectangulaire.

7. Composant détecteur à effet Hall selon l'une des revendications 1 à 6, **caractérisé en ce que** le générateur de signal (4) est intégré dans le composant détecteur à effet Hall.
